# EUROPEAN PATENT SPECIFICATION

(11) **EP 3 866 573 B1**
(45) Date of publication and mention of the grant of the patent: **30.04.2025**
(21) Application number: 20157322.7
(22) Date of filing: 14.02.2020
(51) Int. Cl.: H05K 3/30, H05K 7/12, H01G 2/04, H01G 2/06, H01G 9/08, H01G 11/82, H05K 5/00, H01G 11/78

(54) **CAPACITOR SUPPORT FOR MOUNTING IN A HOUSING FOR A PRINTED CIRCUIT BOARD**
KONDENSATORTRÄGER ZUR MONTAGE IN EINEM GEHÄUSE EINER LEITERPLATTE
SUPPORT DE CONDENSATEUR À MONTER DANS UN BOÎTIER POUR UNE CARTE DE CIRCUIT IMPRIMÉ

(43) Date of publication of application: 18.08.2021
(73) Proprietor: Veoneer Sweden Safety Systems AB, 10302 Stockholm (SE)
(72) Inventor: KUREK, Denis, 95800 Cergy-Pontoise (FR)
(74) Representative: Reichert & Lindner Partnerschaft Patentanwälte

(56) References cited:
- EP-A1- 2 919 565
- WO-A1-2016/096882
- DE-A1- 102008 033 205
- DE-A1- 102011 114 965
- GB-A- 2 459 017
- US-A1- 2018 263 121

## Description

### FIELD OF THE INVENTION

The invention relates to a capacitor support carrying a capacitor, wherein the capacitor support is mounted in a housing for a printed circuit board. The housing comprises at least a housing base and a housing cover.

### DESCRIPTION OF THE BACKGROUND ART

International patent application WO 2019/005616 A1 is directed to a surface mount coupling capacitor and a circuit board containing a surface mount coupling capacitor. The coupling capacitor includes a main body containing at least two sets of alternating dielectric layers and internal electrode layers. The coupling capacitor includes external terminals electrically connected to the internal electrode layers wherein the external terminals are formed on a top surface of the coupling capacitor and a bottom surface of the coupling capacitor opposing the top surface of the coupling capacitor.

British Patent Application GB 2 459 017 A discloses a capacitor support which is designed to provide a connection between the capacitor and a printed circuit board. The printed circuit board is contained in a housing, which naturally comprises a housing base and a housing cover. The capacitor support is mounted by legs to the printed circuit board.

International patent application WO 2016/096882 A1 discloses that the capacitor is connected to the printed circuit board. The cover of the housing has paired clips on its inner side and the clips are adapted to receive and retain the capacitor. The grip of the clips can be loosened and the cover can be removed, while the capacitor remains in the housing. The removal of the cover enables easy inspection of the electronic components inside the housing.

International patent application WO 2010/059977 A2 discloses a solderless capacitor mount assembly including a housing having a base portion and a cover portion. The cover portion and base portion are couplable to each other so as to secure a capacitor to the housing. The assembly further includes at least one connector configured to couple the assembly to a printed circuit board, and at least one electrical contact configured to contact a respective at least one lead of the capacitor and provide an electrical connection for the capacitor.

US patent application US 2015/047887 A1 discloses a mounting circuit board of a multilayer ceramic capacitor. First and second internal electrodes are alternately exposed to both end surfaces of the ceramic body. The first and second external electrodes extend from both end surfaces of the ceramic body to a portion of a lower surface thereof. A printed circuit board has first and second electrode pads so that the first and second external electrodes are mounted thereon.

Chinese utility model CN 207818380 U discloses an electrolytic capacitor mount.

Chinese utility model CN 207282326 U relates to a specific super capacitor module group. A super capacitor module has a shell and an upper cover. The upper cover is connected to the shell, anode and cathode connection of the super capacitor module. The super capacitor module includes U shaped steel, circuit board and a plurality of super capacitors. The supercapacitor unit is fixed in on the circuit board and the circuit board is fixed in the recess of U-shaped steel.

### SUMMARY OF THE INVENTION

It is an object of the present invention to provide a capacitor support for mounting in a housing for a printed circuit board, which saves space on a printed circuit board and enables a simple and precise mounting of the capacitor support.

The above object is achieved by a capacitor support for mounting in a housing for a printed circuit board which comprises the features of claim 1.

According to an embodiment of the invention, a capacitor support is developed for mounting in a housing for a printed circuit board. The capacitor support is configured to be placed inside the housing. The housing comprises at least a housing base and a housing cover. The capacitor support comprises a base plate. A plurality of flexible arms is attached to or integrally formed on the base plate of the capacitor support and extends upwards from the base plate. The flexible arms are configured such that they cooperate with a capacitor to be mounted in the capacitor support, which is mounted to an inner surface of the housing cover. The capacitor is held by the capacitor support in a form and force fitting manner.

The advantage of the present invention is that a lot of space on a printed circuit board is saved, because the capacitor support of the invention is mounted inside the housing onto the inner surface of the housing cover. In other words, the capacitor is held by the inventive mounting method above the printed circuit board Furthermore, the configuration of the capacitor support according to invention, which is preferably made from a thermoplastic polymer, facilitates the mounting procedure of the capacitor support and does not cause any stress or damage to the printed circuit board.

According to the invention the base plate of the capacitor support carries a mounting structure for electrically connecting the capacitor to the printed circuit board. A possible application for the invention is the use of the capacitor support in a housing of an engine control unit (ECU) for a vehicle. The capacitor or capacitors positioned by one or more capacitor supports provide an energy reserve for the ECU.

According to an embodiment of the invention, the capacitor support has four pairs of flexible arms which cooperate with a capacitor to be mounted in the housing in a form and force fitting manner. It is noted that the number of pairs of flexible arms should not be regarded as a limitation of the invention. It is evident for a skilled person in the art that the number of pairs of flexible arms should be selected such that a secure and reliable fixation of the capacitor is guaranteed.

According to an embodiment of the invention, the base plate carries a mounting structure for electrically connecting the capacitor, positioned by the capacitor support, to the circuitry of the printed circuit board.

According an embodiment of the invention, for mounting the capacitor support, the base plate has a plurality of ears. Each ear cooperates with a corresponding crimp on the inner surface of the inner housing cover. Preferably, the ears and the crimps are distributed homogeneously around the capacitor support. This enables a homogeneous force for holding the capacitor support to the inner surfaces of the housing cover. According a further embodiment of the invention, in order to achieve a correct positioning of the capacitor support, an underside of the base plate carries a plurality of pins which fit in a poka yoke manner in corresponding holes of the housing cover.

According to a further embodiment of the invention, the underside of the base plate carries a plurality of pins, which fit in a poka yoke manner into corresponding holes of the housing cover. The pins are designed such that the pins overtop a outer surface of the housing cover. Preferably, the holes of the housing cover have a larger diameter at the outer surface of the housing cover than a diameter of the pins. The holes at the outer surface of the housing cover form a pot-like hole into which a portion of the pins is melted. Finally, the melted material of the pins is flush with the outer surface of the housing cover. Once the material (e. g. thermoplastic polymer) is solidified, the capacitor support is fixed to the housing cover.

According to a further embodiment of the invention, the capacitor support is injection moulded directly onto the inner surface housing base. According to a further embodiment of the invention, the housing cover has at least two positioning pins for a mould which is used to form the capacitor support and to fill a plurality of holes in the housing cover with the material of the capacitor support. Here again the material (e. g. thermoplastic polymer) solidifies in the holes and the capacitor support is firmly and permanently attached to the inner surface of the housing cover.

According to an additional embodiment of the invention, the base plate of the capacitor support has formed at least two holes. Through each of the at least two holes a corresponding stud reaches, which is positioned on the inner surface of the housing cover. In a further embodiment, in order to fix the capacitor support permanently to the inner surface of the housing cover, a head is formed on each stud, preferably by a cold stamping process. The head fixes the capacitor support permanently to the inner surface of the housing cover.

For carrying out another fixing method of the capacitor support to the inner surface of the housing cover, in an embodiment of the invention, the capacitor support comprises starlocks. Each starlock is pushed over the corresponding stud and is in contact with the base plate of the capacitor support and thereby fixes the capacitor support to the inner surface of the housing cover.

Preferably, each stud is made from metal.

### BRIEF DESCRIPTION OF THE DRAWINGS

The numerous advantages of the disclosure may be better understood by those skilled in the art by reference to the accompanying figures in which:
**Figure 1** is a perspective, exploded view of an embodiment of a housing for an electric circuitry which requires some energy reserve capabilities according to prior art.
**Figure 2** is a perspective view of one embodiment of a capacitor support according to the invention.
**Figure 3** is a perspective view of the capacitor support of Fig. 2 in relation to an embodiment of the mounting structure of a housing cover.
**Figure 4** is a perspective the capacitor support of Fig. 2 mounted to the inner surface of the housing cover according to the embodiment of Fig. 3.
**Figure 5** is a perspective view of a further embodiment according to the invention of a capacitor support in relation to an embodiment of the mounting structure of the housing cover.
**Figure 6** is a perspective view of the capacitor support mounted to the inner surface of the housing cover according to the embodiment of Fig. 5.
**Figure 7** is a side view of the embodiment of the capacitor support of Fig. 5 which is positioned on the inner surface of the housing cover.
**Figure 8** is a perspective view of the outer surface of the housing cover.
**Figure 9** is a perspective, partly cut away view of the capacitor support mounted onto the inner surface of the housing cover.
**Figure 10** is a perspective view of another embodiment according to the invention of a capacitor support mounted onto the inner surface of the housing cover.
**Figure 11** is a perspective, partly cut away view of the embodiment shown in Fig. 10.
**Figure 12** is a perspective view of an additional embodiment according to the invention of a capacitor support in relation to an embodiment of a mounting structure of the housing cover.
**Figure 13** is a perspective view of the capacitor support positioned by the mounting structure of the housing cover.
**Figure 14** is a perspective of the capacitor support mounted to the inner surface of the housing cover.
**Figure 15** is a perspective of a further embodiment according to the invention of a capacitor support in relation to an embodiment of a mounting structure of the housing cover.
**Figure 16** is a perspective of the capacitor support mounted onto the inner surface of the housing cover.

### DETAILED DESCRIPTION

Same reference numerals refer to same elements or elements of similar function throughout the various figures. Furthermore, only reference numerals necessary for the description of the respective figure are shown in the figures. The shown embodiments represent only examples of how the invention can be carried out. This should not be regarded as a limitation of the invention.

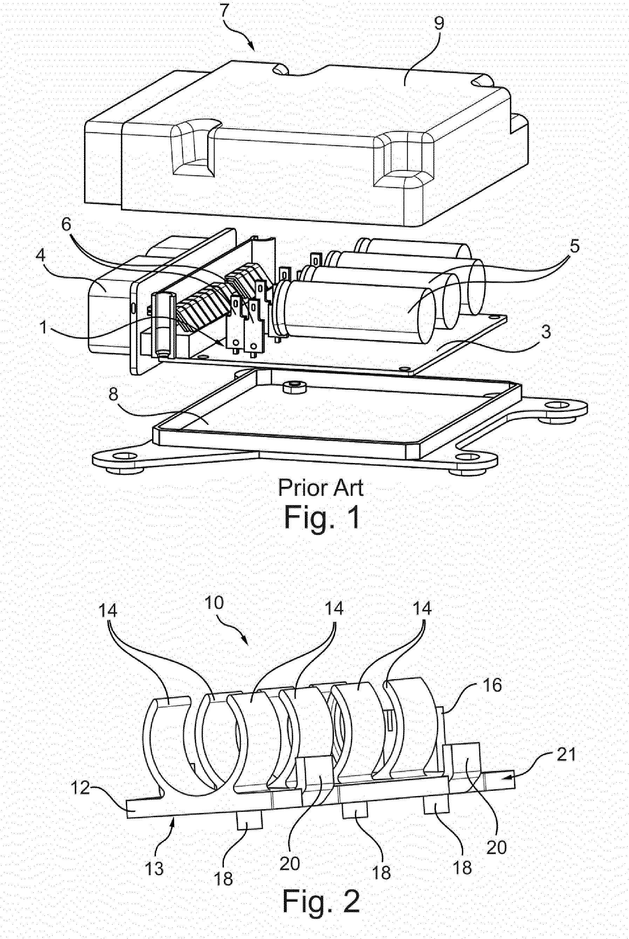

**Figure 1** shows a perspective, exploded view of an embodiment of a housing 7 for an electric circuitry 1 capabilities according to prior art. The electric circuitry 1 requires some energy reserve capabilities. According to the prior art embodiment shown here, the electric circuitry 1, together with the housing 7, is an engine control unit (ECU) for a vehicle (not shown); however, the invention is not limited to an ECU. The housing 7 has a housing base 8 and a housing cover 9. The housing base 8, the housing cover 9 and an electric connector 4 enclose a circuit board 3 and at least one capacitor 5. A plurality of contact pins 6 are attached to the circuit board 3 to provide electric contact between the at least one capacitor 5 and the circuit board 3. According to an embodiment of the invention, the housing base 8 can be a die cast plate; however, the invention is not limited to a die cast plate. The housing cover 9 can be made of plastic. In case the field of application is vehicles, the housing cover 9 for the electric circuitry 1 can be made of polybutylene terephthalate (PBT GF 30), which is a 30% glass fibre reinforced, medium viscous polybutylene terephthalate (PBT) with high stiffness and toughness as well as high dimensional stability and chemical resistance. However, the invention is not limited to this specific configuration of the housing cover 9. Typical applications for PBT are technical and precision parts in automobile, industrial, and appliances industry.

**Fig. 2** is a perspective view of one embodiment of a capacitor support 10 according to the invention. The capacitor support 10 comprises a base plate 12. The base plate 12 carries a plurality of flexible arms 14 which are designed to cooperate and/or hold a capacitor 5 (see Fig. 1) in a form and force fitting manner. For example, the embodiment shown here can hold a capacitor 5 which has a cylindrical shape, but other forms of the capacitor 5 and corresponding shapes of the flexible arms 14 are possible without leaving the scope of claims. Furthermore, the base plate 12 has a mounting structure 16 formed thereon which is used for electrically connecting the capacitor 5 to the printed circuit board 3. Preferably, the capacitor support 10 is formed by an injection moulding process. The material of the capacitor support 10 is, for example, a thermoplastic polymer.

The embodiment of the capacitor support 10 as shown in Fig. 2 has a plurality of ears 20 formed at an outer edge 21 of the base plate 12. The ears 20 are oriented perpendicular to the base plate 12. An underside 13 of the base plate 12 carries a plurality of pins 18.

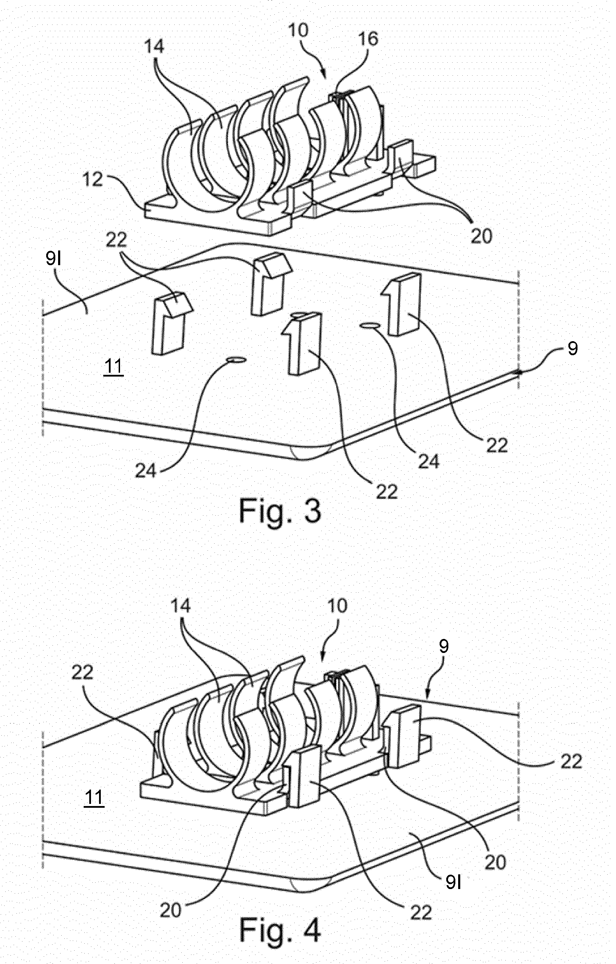

**Fig. 3** and **Fig. 4** are perspective views of the mounting process of the capacitor support 10 (shown in Fig. 2) to an inside 11 or an inner surface 91 of the housing cover 9. The housing cover 9 has a plurality of holes 24 into which the pins 18 (see Fig. 2) of the underside 13 of the base plate 12 fit. The pins 18 of the underside 13 of the base plate 12 and the respective holes 24 of the housing cover 9 are arranged in a poka yoke manner. Poka yoke has the advantage that the capacitor support 10 is positioned in the correct manner, i.e. fixed and in the desired position, to the inner surface 91 of the housing cover 9. In order to fix the capacitor support 10 to the housing cover 9, the housing bas cover 9 has a plurality of crimps 22 which cooperate with corresponding ears 20 of the base plate 12 of the capacitor support 10. As shown in **Fig. 4****,** the capacitor support 10 is mounted to the inner surface 91 of the housing cover 8. The crimps 22 on the inner surface 9I of the housing cover 9 operate with corresponding ears 20 of the base plate 12 and firmly attach the capacitor support 10 to the inner surface 91 of the housing cover 9.

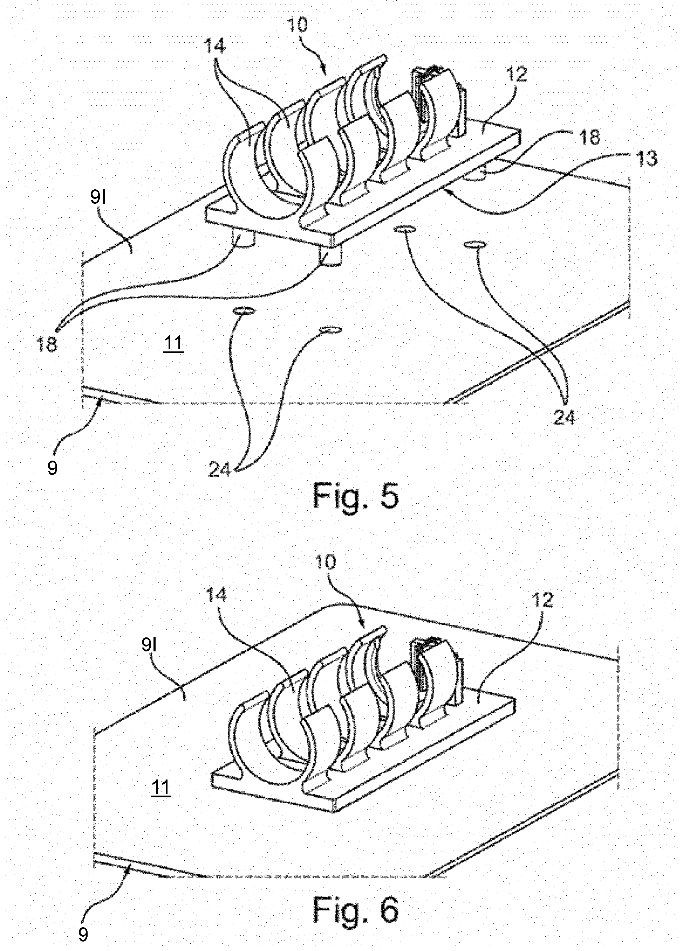

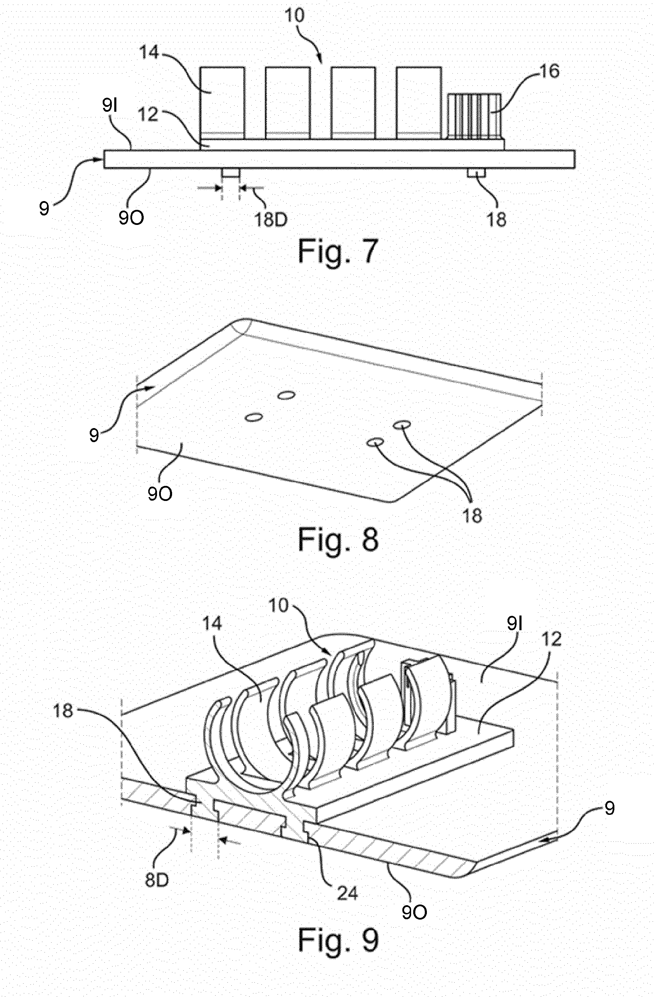

**Fig. 5 to Fig. 9** show a further embodiment for mounting the capacitor support 10 onto the inside 11 of the housing cover 8. **Fig. 5** is a perspective view of a further embodiment of a capacitor support 10 according to the invention in relation to an embodiment of the mounting structure 16 (see Fig. 7) of the housing cover 9. The capacitor support 10 has a plurality of pins 18 formed at an underside 13 of the base plate 12. A plurality of holes 24 constitute a mounting possibility of the housing cover 9. The pins 18 at the underside 13 of the base plate 12 and the holes 24 in the housing cover 9 are arranged as well in a poka yoke manner, which allows correct positioning of the capacitor support 10 on the inner surface 91 of the housing cover 8. In the embodiment described here, the underside 13 of the base plate 12 carries four pins 18 for positioning and mounting the capacitor support 10 to the inner surface of the housing cover 9. It has to be noted that the number of pins 18 is used for describing the invention and should not be used to limit the scope of the invention. The correct positioning of the capacitor support 10, as shown in **Fig. 6****,** is achieved when the underside 13 of the base plate 12 rests on the inner surface 91 of the housing cover 9.

**Fig. 7** shows a side view of the embodiment of capacitor support 10 of Fig. 5 which is positioned on the inner surface 91 of the housing cover 9. The pins 18 of the underside 13 of the base plate 12 overtop the outer surface 9L of the housing cover 9. In order to mount the capacitor support 10 permanently to the inner surface 91 of the housing cover 9, the overtop portion of the pins 18 is melted for example by a welding process with a laser. **Fig. 8** is a perspective of the outer surface 91 of the housing cover 9. After the welding process the pins 18 are flush with the outer surface 9I of the housing cover 9.

**Fig. 9** is a perspective, partly cut away view of capacitor support 10 mounted on the inner surface 91 of the housing cover 9. The holes 24 in the housing cover 9 have a larger diameter 8D at the outer surface 9O of the housing cover 9 than a diameter 18D of the pins 18. The larger holes 24 at the outer surface 9O of the housing cover 9 have a pot-like form. During the welding process of a portion of the pins 18, the liquefied material of the pins 18 fills the pot-like form. Consequently, the pins 18 are flush with the outer surface 9O of the housing cover 9. After the hardening of the melted material of the pins 18, the capacitor support 10 is permanently fixed to the inner surface 91 of the housing cover 9.

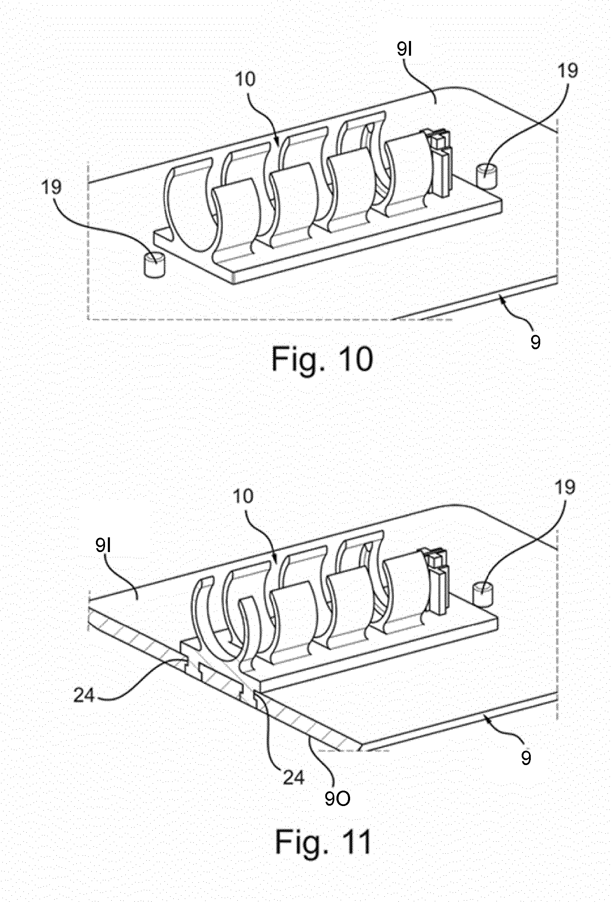

**Fig. 10** and **Fig. 11** show perspective views of another embodiment of a capacitor support 10 mounted onto inner surface 91 of the housing cover 9 according to the invention. The capacitor support 10 is, for example, injection moulded directly onto the inner surface 91 of the housing cover 9. The injection moulding process is carried out in that the mould (not shown) is positioned over the inner surface 91 of the housing cover 9. The correct positioning of the mould is achieved by at least two positioning pins 19 on inner cover 91 of the housing cover 9. As shown in Fig. 5, the housing cover 9 has a plurality of holes 24. During the injection process, the material (e. g. thermoplastic polymer) of the capacitor support 10 flows as well into the holes 24, preferably four holes 24, of the housing cover 9. The holes 24 are used to keep the capacitor support 10 in place. At the inner surface 9I, the holes 24 have a form which is already described with respect to Fig. 9.

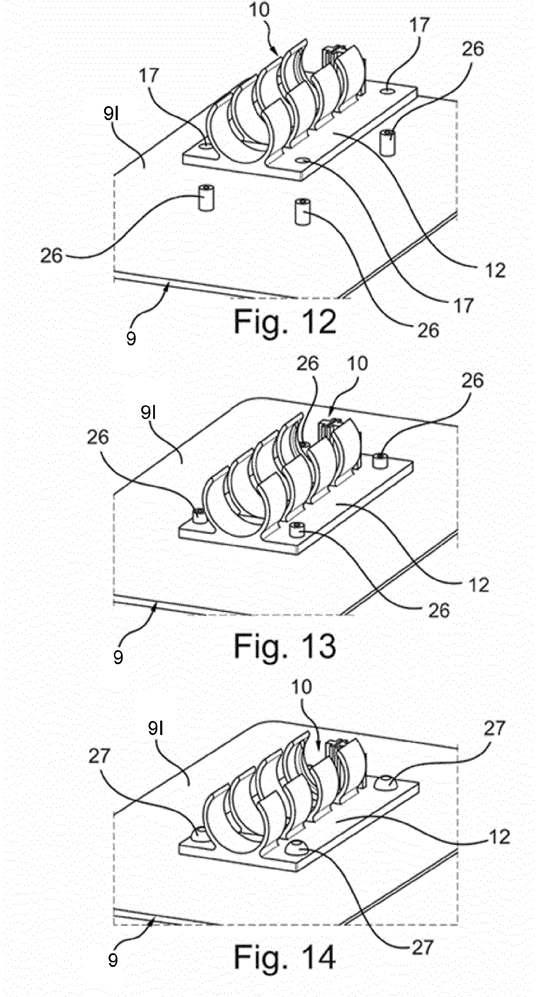

**Fig. 12 to Fig. 14** describe an additional embodiment for mounting and fixing the capacitor support 10 inner surface 91 of the housing cover 9 according to the invention. As shown in **Fig. 12****,** the inner surface 91 of the housing cover 9 carries a plurality of studs 26. The base plate 12 of the capacitor support 10 has formed at least two holes 17. The capacitor support 10 is positioned such that one stud 26 reaches through one hole 17 of the base plate 12 (see Fig. 13). Preferably, the studs 26 are made of metal. In order to fix the capacitor support 10 to the inner surface 91 of the housing cover 9, the studs 26 are deformed by a cold stamp process. As a result of the cold stamp process (see Fig. 14) a head 27 is formed per each stud 26. The heads 27 firmly attach the capacitor support 10 to the inner surface 91 of the housing cover 9. Preferably, four studs 26 are provided on the inner surface 91 of the housing cover 9.

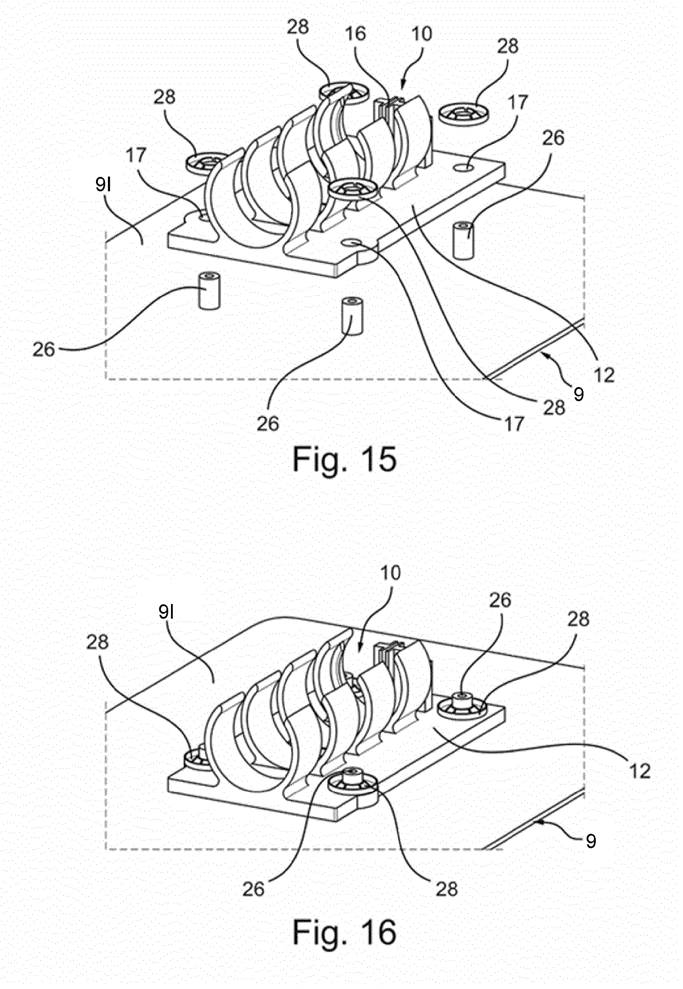

**Fig. 15** and **Fig. 16** describe a modified embodiment for mounting and fixing the capacitor support 10 to the inner surface 91 of the housing cover 9 according to the invention. The inner surface 91 of the housing cover 9 carries as plurality of studs 26. The base plate 12 of the capacitor support 10 has formed at least two holes 17. The capacitor support 10 is positioned such that the studs 26 reach trough the corresponding holes 17 provided in the base plate 12 of the capacitor support 10. **Fig. 16** shows the step of firmly attaching the capacitor support 10 to the inner surface 91 of the housing cover 9. A respective starlock 28 is placed over each of the plurality of studs 26, and each starlock 28 is pushed on each of the studs 26 until the capacitor support 10 is attached to the inner surface 91 of the housing cover 9. Preferably, the studs 26 are metal studs as mentioned above. Furthermore, three or four studs 26 provide the best fixing of the capacitor support 10 to the inner surface 9I of the housing cover 8.

It is believed that the present disclosure and many of its attendant advantages will be understood by the foregoing description, and it will be apparent that various changes may be made in the form, construction and arrangement of the components without departing from the disclosed subject matter or without sacrificing all of its material advantages. The form described is merely explanatory, and it is the intention of the following claims to encompass and include such changes. Accordingly, the scope of the invention should be limited only by the claims appended hereto.

### LIST OF REFERENCE NUMERALS

- 1: Electric circuitry
- 3: Circuit board
- 4: Connector
- 5: Capacitor
- 6: Contact pin
- 7: Housing
- 8: Housing base
- 8D: Diameter
- 9: Housing cover
- 91: Inner surface
- 9O: Outer surface
- 10: Capacitor support
- 11: Inside
- 12: Base plate
- 13: Underside
- 14: Flexible arms
- 16: Mounting structure for circuit board
- 17: Hole
- 18: Pin
- 18D: Diameter
- 19: Positioning pin
- 20: Ear
- 21: Outer edge
- 22: Crimp
- 24: Hole
- 26: Stud
- 27: Head
- 28: Starlock

## Claims

1. A capacitor support (10) carrying a capacitor (5), wherein the capacitor support (10) is mounted in a housing (7) for a printed circuit board (3) inside the housing (7), which comprises at least a housing base (8) and a housing cover (9),
**characterized by**
a base plate (12);
a plurality of flexible arms (14) extending upwards from the base plate (12) and cooperating in a form and force fitting manner with the capacitor (5), wherein the capacitor support (10) is mounted to an inner surface (9I) of the housing cover (9) and above the printed circuit board (3); and
a mounting structure (16) formed on the base plate (12) of the capacitor support (10) for electrically connecting the capacitor (5) from the housing cover (9) above the printed circuit board (3) to the printed circuit board (3).

2. The capacitor support (10) as claimed in claim 1, wherein the base plate (12) has a plurality of ears (20) each of which cooperates with a crimp (22) on the inner surface (91) of the housing cover (9).

3. The capacitor support (10) as claimed in claim 2, wherein an underside (13) of the base plate (12) carries a plurality of pins (18) which fit in a poka yoke manner in respective holes (24) of the housing cover (9).

4. The capacitor support (10) as claimed in claim 1, wherein an underside (13) of the base plate (12) carries a plurality of pins (18), which fit in a poka yoke manner into respective holes (24) of the housing cover (9) and the pins (18) overtop an outer surface (9O) of the housing cover (9).

5. The capacitor support (10) as claimed in claim 4, wherein the holes (24) of the housing cover (9) have a larger diameter (8D) at the outer surface (9O) of the housing cover (9) than a diameter (18D) of the pins (18) and form a pot-like hole into which a portion of the pins (18) is melted to be flush with the outer surface (9O) of the housing cover (9) and thereby fixing the capacitor support (10) to the housing cover (9).

6. The capacitor support (10) as claimed in claim 1, wherein the capacitor support (10) is injection moulded directly onto the inner surface (91) of the housing cover (9).

7. The capacitor support (10) as claimed in claim 6, wherein the housing cover (9) has at least two positioning pins (19) for a mould in order to form the capacitor support (10) and to fill a plurality of holes (24) in the housing cover (9) with the material of the capacitor support (10) for firmly and permanently attaching the capacitor support (10) in place on the inner surface (91) of the housing cover (9).

8. The capacitor support (10) as claimed in claim 1, wherein the base plate (12) of the capacitor support (10) has formed at least two holes (17) through each of which a stud (26), positioned on the inner surface (9I) of the housing cover (9), reaches.

9. The capacitor support (10) as claimed in claim 8, wherein a head (27) is formed on each stud (26) by a cold stamping process and the head (27) fixes the capacitor support (10) permanently to the inner surface (91) of the housing cover (9).

10. The capacitor support (10) as claimed in claim 8, wherein a starlock (28) is pushed over each stud (26) and in contact with the base plate (12) of the capacitor support (10) and thereby fixing the capacitor support (10) onto the inner surface (91) of the housing cover (9).

11. The capacitor support (10) as claimed in claim 9 or 10, wherein each stud (26) is made from metal.

## Patentansprüche

1. Kondensatorträger (10), der einen Kondensator (5) trägt, wobei der Kondensatorträger (10) in einem Gehäuse (7) für eine gedruckte Leiterplatte (3) innerhalb des Gehäuses (7) montiert ist, das mindestens einen Gehäuseboden (8) und einen Gehäusedeckel (9) aufweist
**gekennzeichnet durch**
eine Grundplatte (12)
eine Vielzahl von flexiblen Armen (14), die sich von der Grundplatte (12) nach oben erstrecken und form- und kraftschlüssig mit dem Kondensator (5) zusammenwirken, wobei der Kondensatorträger (10) an einer Innenfläche (91) des Gehäusedeckels (9) und oberhalb der Leiterplatte (3) angebracht ist; und
eine auf der Grundplatte (12) des Kondensatorträgers (10) ausgebildete Montagestruktur (16) zum elektrischen Verbinden des Kondensators (5) vom Gehäusedeckel (9) oberhalb der Leiterplatte (3) mit der Leiterplatte (3).

2. Kondensatorträger (10) nach Anspruch 1, wobei die Grundplatte (12) eine Vielzahl von Ohren (20) aufweist, von denen jedes mit einer Klemme (22) an der Innenfläche (91) des Gehäusedeckels (9) zusammenwirkt.

3. Kondensatorträger (10) nach Anspruch 2, wobei eine Unterseite (13) der Grundplatte (12) eine Vielzahl von Stiften (18) trägt, die poka-jochartig in entsprechende Löcher (24) des Gehäusedeckels (9) passen.

4. Kondensatorträger (10) nach Anspruch 1, wobei eine Unterseite (13) der Grundplatte (12) eine Vielzahl von Stiften (18) trägt, die poka-jochartig in entsprechende Löcher (24) des Gehäusedeckels (9) passen und die Stifte (18) eine Außenfläche (9O) des Gehäusedeckels (9) überragen.

5. Kondensatorträger (10) nach Anspruch 4, wobei die Löcher (24) des Gehäusedeckels (9) an der Außenfläche (9O) des Gehäusedeckels (9) einen größeren Durchmesser (8D) haben als ein Durchmesser (18D) der Stifte (18) und ein topfartiges Loch bilden, in das ein Teil der Stifte (18) bündig mit der Außenfläche (9O) des Gehäusedeckels (9) eingeschmolzen ist und dadurch den Kondensatorträger (10) am Gehäusedeckel (9) befestigt.

6. Kondensatorträger (10) nach Anspruch 1, wobei der Kondensatorträger (10) direkt auf die Innenfläche (91) des Gehäusedeckels (9) gespritzt ist.

7. Kondensatorträger (10) nach Anspruch 6, wobei der Gehäusedeckel (9) mindestens zwei Positionierstifte (19) für eine Form aufweist, um den Kondensatorträger (10) zu formen und eine Vielzahl von Löchern (24) im Gehäusedeckel (9) mit dem Material des Kondensatorträgers (10) zu füllen, um den Kondensatorträger (10) fest und dauerhaft an der Innenfläche (91) des Gehäusedeckels (9) zu befestigen.

8. Kondensatorträger (10) nach Anspruch 1, wobei in der Grundplatte (12) des Kondensatorträgers (10) mindestens zwei Löcher (17) ausgebildet sind, durch die jeweils ein an der Innenfläche (91) des Gehäusedeckels (9) angeordneter Bolzen (26) hindurchreicht.

9. Kondensatorträger (10) nach Anspruch 8, wobei an jedem Bolzen (26) ein Kopf (27) durch ein Kaltprägeverfahren angeformt ist und der Kopf (27) den Kondensatorträger (10) dauerhaft an der Innenfläche (91) des Gehäusedeckels (9) fixiert.

10. Kondensatorträger (10) nach Anspruch 8, wobei ein Sternverschluss (28) über jeden Bolzen (26) geschoben wird und in Kontakt mit der Grundplatte (12) des Kondensatorträgers (10) steht und dadurch den Kondensatorträger (10) auf der Innenfläche (91) des Gehäusedeckels (9) fixiert.

11. Kondensatorträger (10) nach Anspruch 9 oder 10, wobei jeder Bolzen (26) aus Metall hergestellt ist.

## Revendications

1. Support de condensateur (10) portant un condensateur (5), dans lequel le support de condensateur (10) est monté dans un boîtier (7) pour une carte de circuit imprimé (3) à l'intérieur du boîtier (7), qui comprend au moins une base de boîtier (8) et un couvercle de boîtier (9),
**caractérisé par**
une plaque de base (12) ;
une pluralité de bras flexibles (14) s'étendant vers le haut à partir de la plaque de base (12) et coopérant de manière à s'adapter à la forme et à la force du condensateur (5), dans lequel le support du condensateur (10) est monté sur une surface intérieure (9I) du couvercle du boîtier (9) et au-dessus de la carte de circuit imprimé (3) ; et
une structure de montage (16) formée sur la plaque de base (12) du support de condensateur (10) pour connecter électriquement le condensateur (5) du couvercle du boîtier (9) au-dessus de la carte de circuit imprimé (3) à la carte de circuit imprimé (3) .

2. Support de condensateur (10) selon la revendication 1, dans lequel la plaque de base (12) comporte une pluralité d'oreilles (20) dont chacune coopère avec un sertissage (22) sur la surface intérieure (91) du couvercle du boîtier (9).

3. Support de condensateur (10) selon la revendication 2, dans lequel une surface inférieure (13) de la plaque de base (12) porte une pluralité de goupilles (18) qui s'insèrent de manière poka yoke dans des trous (24) respectifs du couvercle du boîtier (9).

4. Support de condensateur (10) selon la revendication 1, dans lequel une surface inférieure (13) de la plaque de base (12) porte une pluralité de goupilles (18), qui s'insèrent de manière poka yoke dans des trous (24) respectifs du couvercle du boîtier (9) et les goupilles (18) surmontent une surface extérieure (9O) du couvercle du boîtier (9).

5. Support de condensateur (10) selon la revendication 4, dans lequel les trous (24) du couvercle du boîtier (9) ont un diamètre (8D) plus grand à la surface extérieure (9O) du couvercle du boîtier (9) qu'un diamètre (18D) des goupilles (18) et forment un trou en forme de pot dans lequel une partie des goupilles (18) est fondue pour affleurer la surface extérieure (9O) du couvercle du boîtier (9) et ainsi fixer le support de condensateur (10) au couvercle du boîtier (9).

6. Support de condensateur (10) selon la revendication 1, dans lequel le support de condensateur (10) est moulé par injection directement sur la surface intérieure (91) du couvercle du boîtier (9).

7. Support de condensateur (10) selon la revendication 6, dans lequel le couvercle du boîtier (9) comporte au moins deux broches de positionnement (19) pour un moule afin de former le support de condensateur (10) et de remplir une pluralité de trous (24) dans le couvercle du boîtier (9) avec le matériau du support de condensateur (10) pour fixer fermement et de façon permanente le support de condensateur (10) en place sur la surface intérieure (91) du couvercle du boîtier (9).

8. Support de condensateur (10) selon la revendication 1, dans lequel la plaque de base (12) du support de condensateur (10) a formé au moins deux trous (17) à travers chacun desquels passe un goujon (26), positionné sur la surface intérieure (91) du couvercle du boîtier (9).

9. Support de condensateur (10) selon la revendication 8, dans lequel une tête (27) est formée sur chaque goujon (26) par un processus d'estampage à froid et la tête (27) fixe le support de condensateur (10) de façon permanente à la surface intérieure (91) du couvercle du boîtier (9).

10. Support de condensateur (10) selon la revendication 8, dans lequel une serrure à étoile (28) est poussée sur chaque goujon (26) et en contact avec la plaque de base (12) du support de condensateur (10), fixant ainsi le support de condensateur (10) sur la surface intérieure (9I) du couvercle du boîtier (9).

11. Support de condensateur (10) selon la revendication 9 ou 10, dans lequel chaque goujon (26) est en métal.
